# EUROPEAN PATENT APPLICATION

(11) **EP 2 015 343 A2**
(43) Date of publication of application: **14.01.2009**
(21) Application number: 08160145.2
(22) Date of filing: 10.07.2008
(51) Int. Cl.: H01J 37/32, H01L 21/683

(54) **High temperature cathode for plasma etching**

(30) Priority: 13.07.2007 US 949833 P
(71) Applicant: Applied Materials, Inc., Santa Clara, CA 95054 (US)
(72) Inventor: Yendler, Boris, Saratoga, CA 95070 (US); Matyushkin, Alexander, San Jose, CA 95136 (US); Koosau, Denis, Hayward, CA 94544 (US); Egami, Glen, San Jose, CA 95132 (US)
(74) Representative: Zimmermann & Partner

(57) **Abstract**

Emodiments of the present invention generally relate to a cathode 100 suitable for use in high temperature plasma etch applications. In one embodiment, the cathode 100 includes a ceramic electrostatic chuck 104 secured to a base 102. The base 102 has cooling conduits formed therein. A rigid support ring 110 is disposed between the chuck 104 and the base 102, thereby maintaining the chuck and the base in a spaced-apart relation.

## Description

Embodiments of the present invention generally relate to semiconductor substrate processing systems. More specifically, the invention relates to a plasma processing cathode, in particular to a high temperature cathode suitable for plasma etching.

In semiconductor wafer processing, the trend towards increasingly smaller feature size and line widths have placed a premium on the ability to mask, etch, and deposit material on a semiconductor workpiece, or wafer, with greater precision. Plasma etching is of particular importance in obtaining critical dimensions less than 1.0 micron.

Typically, plasma etching is accomplished by applying a RF power to a working gas supplied over a substrate held by a pedestal in a low pressure environment. The resulting electric field creates a reaction zone that excites the working gas into a plasma. Ions migrate towards the boundary of plasma, and accelerate upon leaving the boundary layer. The accelerated ions produce the energy required to remove, or etch, the target material, which generally is a layer of material disposed on the substrate.

In some plasma etch applications, it is desirable to maintain the substrate at temperatures in excess of 100 degrees Celsius, and up to about 400 degrees Celsius, during processing. Significant challenges in substrate support design must be overcome in order to successfully process substrates at such high temperatures. For example, the large differences in thermal expansion encountered between ceramic and metal components may result in damage to the ceramic component. Moreover, high temperature regions of the substrate support must be isolated from polymer seals generally utilized to prevent leakage between the internal regions of the substrate support, which is typically maintained at substantially ambient pressures, and the vacuum environment surrounding the substrate support. Furthermore, such challenges must be overcome while providing good control of the substrate temperature distribution across the diameter of the substrate. The inability to control substrate temperature uniformity has an adverse effect on process uniformity both within a single substrate and between substrates, device yield and overall quality of processed substrates.

Therefore, there is a need in the art for an improved substrate support suitable for use in high temperature plasma etch applications.

In view of the above, plasma processing cathodes according to independent claims 1, 10, and 13 are provided. Further advantages, features, aspects and details of the invention are evident from the dependent claims, the description and the drawings.

Embodiments of the present invention generally relate to a cathode suitable for use in high temperature plasma etch applications. In one embodiment, the cathode includes a ceramic electrostatic chuck secured to a base. The base has cooling conduits formed therein. A rigid support ring is disposed between the chuck and the base, thereby maintaining the chuck and the base in a spaced-apart relation.

In at least one other embodiment, a cathode includes a gas distribution ring disposed between the base and chuck.

In at least one other embodiment, a cathode further includes a gas passage formed through the base and a gas feed formed through the chuck. The passage and feed are not aligned but fluidly coupled through a gas distribution ring to define a gas delivery path.

In at least one other embodiment, a ceramic baffle disk is disposed in the gas delivery path.

In at least one other embodiment, a cathode further includes an annular spreader plate disposed in a gap defined between the chuck and the base, wherein the annular spreader plate touches the base but not the chuck.

In at least one other embodiment, a clamp ring is utilized to secure the chuck to the base. The clamp ring includes a least two thermal chokes disposed in series between portions of the clamp ring touching the chuck and the base.

In at least one other embodiment, the cathode further includes a stem and a sleeve. The stem is coupled to the chuck and extends through the base. The sleeve is disposed through the stem such that a first gap defined between the stem and base is greater than a second gap defined between the stem and sleeve. A seal disposed between a lower end of the stem and the base to seal the first gap.

In at least one other embodiment, the base further includes a channel coupling the stem to the chuck and extending through the base. The channel vents the first gap through the base.

In another embodiment, a plasma processing cathode includes a base, a ceramic electrostatic chuck and rigid support ring maintaining a bottom of the electrostatic chuck and the base in a spaced-apart relation. The electrostatic chuck has a plurality of gas feeds extending from the bottom surface of the electrostatic chuck to a top surface the electrostatic chuck. A fluid distribution ring is disposed between the base and the electrostatic chuck. The fluid distribution ring is spaced from the base to define an annular channel therebetween. The fluid distribution ring includes a plurality of gas passages configured to direct gas through the fluid distribution ring from the channel to the electrostatic chuck. A plurality of ceramic baffles are disposed in the gas passages.

In yet another embodiment, a plasma processing cathode includes a base having cooling conduits formed therein, a ceramic electrostatic chuck secured to a top surface of the base, and a rigid support ring disposed between the electrostatic chuck and the base. The support ring maintains a lower surface of the electrostatic chuck spaced-apart from the top surface of the base. A flat annular spreader plate is disposed radially inward of the support ring in a gap defined between the lower surface of the electrostatic chuck and the upper surface of the base. A seal is provided to seal the electrostatic chuck to the base in a location outward of the spreader plate, the seal sealingly permitting radial movement of the electrostatic chuck relative to the plate.

The invention is also directed to methods by which the described apparatus operates. It includes method steps for carrying out every function of the apparatus or manufacturing every part of the apparatus.

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments. In the accompanying drawings,

Figure 1 is a sectional perspective view of one embodiment of a substrate support assembly suitable for use in a plasma etch chamber;

Figure 2 is a partial sectional view of the substrate support assembly of Figure 1 depicting one embodiment of a gas distribution ring;

Figure 3A is a partial plan view of a portion of the gas distribution ring disposed on a cooling base, the gas distribution ring having a baffle disk covering a gas inlet formed through the ring;

Figure 3B is a partial plan view of the gas distribution ring of Figure 3A with the baffle disk removed to show the gas inlet;

Figure 4 is another partial sectional view of the substrate support assembly of Figure 1 through the gas distribution ring;

Figure 5 is a perspective view of one embodiment of a baffle disk;

Figure 6 is a partial sectional view of the substrate support assembly of Figure 1 through an inner gas feed;

Figure 7 is a partial sectional view of a substrate support assembly utilizing an E-seal between a cooling base and electrostatic chuck; and

Figure 8 is a sectional perspective view of another embodiment of a substrate support assembly suitable for use in a plasma etch chamber.

To facilitate understanding, identical reference numerals have been used, where possible, to designate identical elements that are common to the figures. It is to be noted, however, that the appended drawings illustrate only typical embodiments of this invention and are therefore not to be considered limiting of its scope, for the invention may admit to other equally effective embodiments.

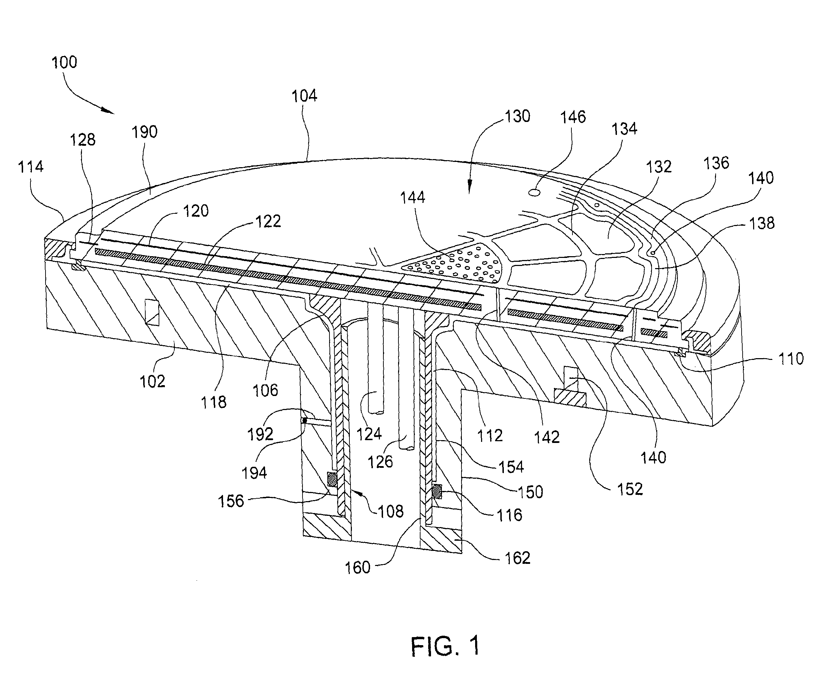

Figure 1 is a sectional isometric view of one embodiment of a high temperature cathode 100 suitable for plasma etching. The cathode 100 may be advantageously utilized in plasma etch reactors, such as the AdvantEdge^{™} Etch reactor, available from Applied Materials, Inc., of Santa Clara, California, among other etch reactors, including suitable reactors available from other manufacturers.

Figure 1 is one embodiment of a cathode 100. The cathode 100 generally includes an electrostatic chuck 104 secured to a cooling base 102. A stem 106 extends from a bottom of the electrostatic chuck 104. The stem 106 may be coupled to the electrostatic chuck 104 by braising or other suitable method. The stem 106 is generally fabricated from a conductive material such as stainless steel.

The electrostatic chuck 104 is supported above the cooling base 102 in a spaced-apart relation. In the embodiment depicted in Figure 1, a support ring 110 is provided between the cooling base 102 and electrostatic chuck 104, such that a gap 118 is maintained between the underside of the electrostatic chuck 104 and the upper surface of the cooling base 102. The gap 118 limits the heat transfer between the electrostatic chuck 104 and cooling base 102. In one embodiment, the distance across the gap 118 between the electrostatic chuck 104 and cooling base 102 is about 0.025 to about 0.045 inches.

To further minimize heat transfer between the electrostatic chuck 104 and cooling base 102, the support ring 110 may be made of a material having a low coefficient of thermal conductivity relative to the base, such as titanium, among other materials. In other embodiments, the support ring 110 may be fabricated from hard anodized aluminum, high temperature plastics or other suitable material. In other embodiments, the support ring 110 is fabricated from a rigid material so that the dimension across the gap 118 is maintained while clamping the chuck 104 to the base 102. In the embodiment depicted in Figure 1, the support ring 110 is fabricated from a rigid plastic, for example a polyimide such as VESPEL^{®}.

In one embodiment, the support ring 110 touches less than 15 percent, for example, 10 percent, of the bottom surface of the electrostatic chuck 104. In the embodiment depicted in Figure 1, the top or crown of the support ring 110 contacting the electrostatic chuck 104 is narrowed to provide a heat choke. Alternatively, the heat flow can be restricted through the ring 110 by choking heat transfer at the bottom of the support ring 110 by means of decreasing contact area between the ring 110 and the cooling base 102 ("reverse crown").

The cooling base 102 is fabricated from a material having good heat transfer, for example, a metal such as stainless steel or aluminum. The cooling base 102 includes one or more fluid conduits 152 formed therein. The conduits 152 are coupled to a fluid source such that the temperature of the cooling base 102 may be selectively heated or cooled. Examples of cooling bases having conduits formed therein to regulate temperature thereof as described in United States Patent Application Serial No. 10/960,874 filed October 7, 2004.

The cooling base 102 also includes a cylinder 150 extending from the lower surface of the cooling base 102. An inside diameter 154 of the cylinder 150 is configured such that a gap 112 is maintained between the cooling base 102 and the stem 106. The lower end of the cylinder 150 includes an inwardly-extending lip 156 which accommodates a gland that secures an o-ring 116. The o-ring 116 provides a pressure barrier between the cooling base 102 and the stem 106.

A shield 108 is utilized to manage the temperature of the stem 106 so that heat passing from the electrostatic chuck 104 does not damage the o-ring 116. The shield 108 increases amount of heat transfer from the stem 106 by about two times. The shield 108 includes a flange 162 and a sleeve 160. The sleeve 160 fits inside the stem 106, such that the heat transfer from the stem 106 is predominantly to the sleeve 160. The sleeve 160 may have a close fit to the stem 106, or have a gap defined therebetween which is less than the gap 112 defined between the stem 106 and the inside diameter 154 of the cooling base 102. The shield 108 provides enough thermal sink to allow the electrostatic chuck 104 to be operated at temperatures in excess of 300 degrees Celsius without damaging the seal 116.

The heat removal from the stem 106 may be conducted by radiation and conduction. The heat removal has to be limited in order to prevent damage to the electrostatic chuck 104 due to high thermal stresses in the ceramic chuck material. Potentially, the gap 112 between the stem 106 and the cooling base 102 may be filled with helium supplied for substrate cooling due to seal leakage. The pressure of the helium in the gap 112 will change significantly during the process cycle, which can lead to an additional repeating thermal stress and breakdown of the stem 106. In order to evacuate helium leaked into the gap 112 and prevent unpredictable heat transfer from the stem 106 to the cooling base 102, the gap 112 may be connected to the chamber by a small channel 192, thereby dumping any helium that may be present in the gap 112 into the chamber in which the cathode is installed. The channel 192 may include a sintered ceramic plug 194 to prevent arcing in the channel 192. Although the channel 192 is shown through the cylinder 150, the channel 192 may be formed in other locations, for example, through the main portion of the base 102 above the conduits 152.

The electrostatic chuck 104 is typically fabricated from aluminum nitride or other suitable material. The electrostatic chuck 104 includes a resistive heater 122 and at least one chucking electrode 120. In one embodiment, the heater 122 is disposed in the middle of the electrostatic chuck 104, while the chucking electrode 120 is disposed between the heater 122 and the upper surface 130. The chucking electrode 120 is also provided with RF power to sustain a plasma within a processing chamber during etching. Power to the chucking electrode 120 and the heater 122 are generally provided through electrical feeds 124, 126 which extend through the hollow interior of the stem 106 and shield 108 to facilitate coupling of the chucking electrode 120 and heater 122 to power sources not shown.

A secondary electrode 128 may be disposed below the chucking electrode 120. The outer edge of the secondary electrode 128 extends beyond the outside edge of the chucking electrode 120. Since the upper surface 130 of the electrostatic chuck 104 is smaller than the substrate fixed on top of the chuck to prevent damage to the chuck by plasma at the edge of the substrate during processing, the electrical field at the edge of the substrate may be distorted and provide a so-called "tilted" etch profile. The secondary electrode 128 is connected to the main RF terminal as the chucking electrode 120 and is provided with generally same electrical potential during etch process. The secondary electrode 128 may also be utilized to prevent and/or remove material deposited on a process kit (e.g., a process ring) supported on a ledge 190 outward and below the upper surface 130 of the electrostatic chuck 104.

The upper surface 130 of the electrostatic chuck 104 generally includes a plurality of mesas 132 separated by a groove network 134. The mesas may include surface features 144, such as bumps, projections, embossments, texture and the like, which are utilized to tailor heat transfer and chucking characteristics of the surface 130. Helium or other suitable heat transfer gas is provided to the groove network 134 through an inner gas feed 140 formed through the electrostatic chuck 104.

The upper surface 130 of the electrostatic chuck 104 additionally includes an outer peripheral channel 136 which is separated from the groove network 134 by an annular ridge 138. Helium or other suitable heat transfer gas is provided to the outer peripheral channel 136 by an outer gas feed 140 so that the gases delivered to the groove network 134 and the outer peripheral channel 136 may be independently controlled. Optionally, one or more gas feeds 140, 142 may be provided to provide a desired distribution of gas in the groove network 134 and outer peripheral channel 136. In the embodiment depicted in Figure 1, one inner gas feed 142 and twelve equally spaced outer gas feeds 140 are formed through the electrostatic chuck 104. Although only one is shown, a plurality of lift pin holes 146 are formed through the cooling base 102 and electrostatic chuck 104.

Optionally, a second annular outer channel (not shown) may be disposed adjacent the outer peripheral channel 136. The second annular outer channel may be utilized to collect contaminants and to decrease the contamination of the rest of chuck surface, thereby increasing chucking performance.

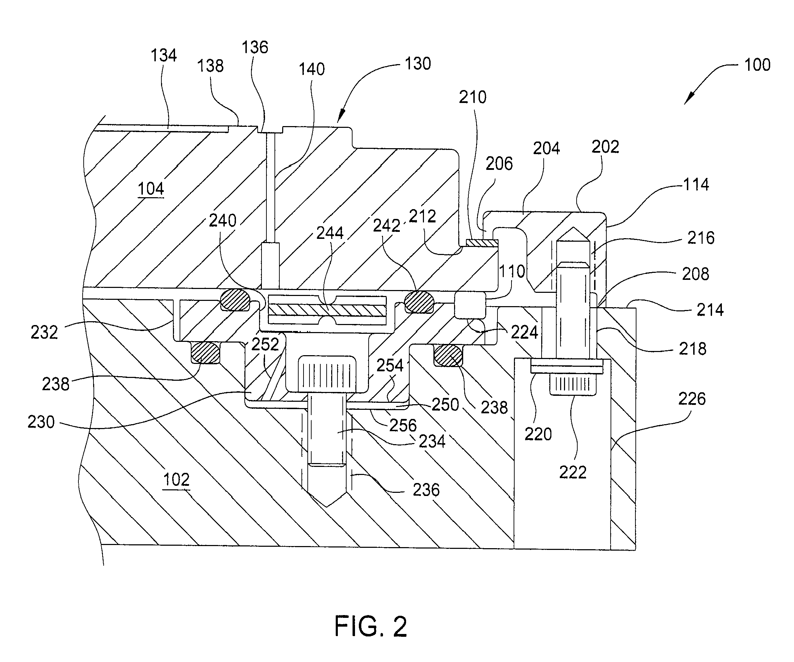

Figure 2 depicts a partial cross-sectional view of one embodiment of the clamp ring 114 of the cathode 100. The clamp ring 114 is fabricated from a rigid material, such as anodized aluminum, titanium, or other suitable material. The material of the clamp ring 114 may be selected to have a low thermal conductivity so that heat transfer between the electrostatic chuck 104 and base 102 is minimized. The clamp ring 114 generally includes an annular body 202 having a flange 204 extending inwardly therefrom. The distal end of the flange 204 includes a downwardly extending lip 206. The flange 204 and lip 206 are dimensioned such that the lip 206 contacts a mounting flange 212 extending radially outward below the ledge 190 of the electrostatic chuck 104 when clamped.

In one embodiment, the clamp ring 114 may be configured to minimize the heat transfer between the electrostatic chuck 104 and the clamp ring 114, thereby preventing or minimizing the formation of lateral temperature gradients in the chuck 104. In one embodiment, the lip 206 may be segmented around the circumference of the flange 204 to minimize the contact between the clamp ring 114 and the electrostatic chuck 104. In another embodiment, the flange 204 may include a region of reduced cross-section as to create a thermal choke between the lip 206 and the body 202, thereby limiting heat transfer therebetween. In another embodiment, a thermal insulation ring 210 may be provided between the lip 206 and the mounting flange 212. The insulation ring 210 may be fabricated from a material having a coefficient of thermal conductivity less than at least one of or both of the electrostatic chuck 104 and ring 114.

The body 202 includes a threaded hole 216 configured to accept a fastener 222. The fastener 222 extends through a clearance hole 218 formed through the cooling base 102. The clearance hole 218 has a diameter sufficient to accommodate differences in thermal expansion between the clamp ring 114 and the cooling base 102 while fastened. One or more washers 220 are utilized to prevent the head of the fastener 222 from extending or binding in the clearance hole 218. A counter bore 226 is provided through the cooling base 202 to facilitate access to the fastener 222. The fastener 222 and washers 220 may be fabricated from a suitable material, and in one embodiment, are fabricated from at nickel alloy, such as HASTELLOY^{®}. In one embodiment, springs (not shown) may be disposed between the head of the fastener 222 and cooling base 102 to bias the clamp ring 114 against the electrostatic chuck 104.

The body 202 may additionally include a ridge 208 extending from a lower surface thereof. The ridge 208 maintains the body 202 in a spaced-apart relation relative to an upper surface 214 of the cooling base 102. The ridge 208 provides a thermal choke between the body 202 and the cooling base 102, such that heat transfer from the periphery of the electrostatic chuck 104 to the cooling base 102 through the clamp ring 114 is minimized. Optionally, the ridge 208 may be segmented into discrete portions to further limit the heat transfer between the body 202 and the cooling base 102.

Also depicted in Figure 2 is a gas distribution ring 230. The gas distribution ring is configured to provide gas to the outer gas feeds 140. The gas distribution ring 230 is disposed in a stepped recess 232 formed in the upper surface 214 of the cooling base 102. A plurality of fasteners 234 are arranged to engage a threaded hole 236 formed in the cooling base 102 to secure the gas distribution ring 230. A plurality of inner and outer ring seals 238 are provided between the gas distribution ring 230 and the base 102 and the stepped recess 232 of the base 102.

A bottom 254 of gas distribution ring 230 is maintained in a spaced-apart relation with a bottom 256 of the stepped recess 232, there by defining an annular channel 250 into which gas is feed through the base 102. One or more feed holes 252 are formed through the gas distribution ring 230 to allow gases in the channel to pass through the gas distribution ring 230.

The gas distribution ring 230 also includes a stepped counter bore 240. An upper portion of the stepped counter bore 240 is configured to receive a baffle disk 244. Each baffle disk 244 is circumscribed by a baffle seal 242 that provides a seal between the gas distribution ring 230 and a lower surface of the electrostatic chuck 104. The baffle seal 242 additionally sealingly circumscribes the outer gas feed 140. In one embodiment, the seals 238, 242 are fabricated from a high temperature elastomer, such as a perfluoroelastomer, one example of which is KALREZ^{®}. In one embodiment, the feed holes 252 break into the stepped counter bore 240 to allow gases to pass from the annular channel 250 through the gas distribution ring 230 and eventually through the outer gas feed 140 of the electrostatic chuck 104.

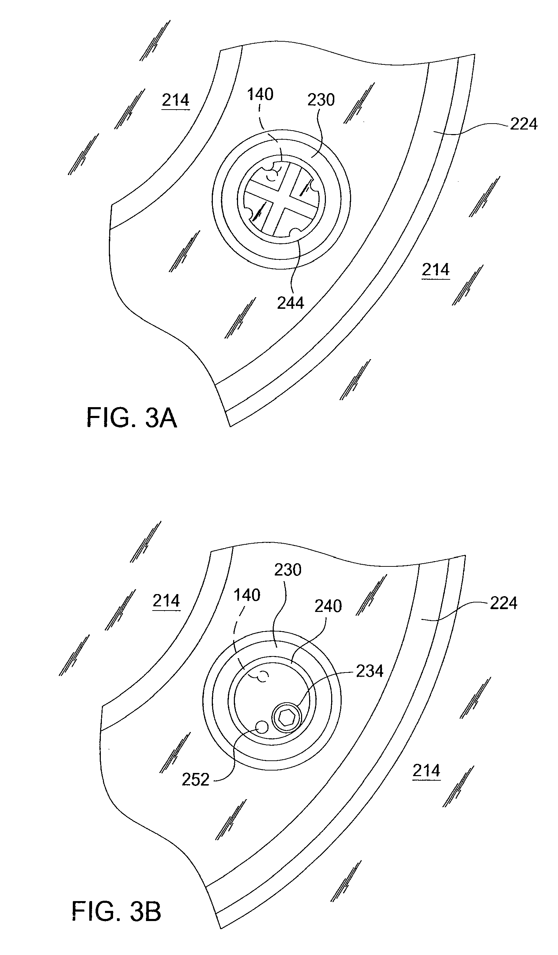

Referring additionally to Figures 3A and 3B, the baffle disk 244 is provided to prevent a direct line of sight exposure of grounded surfaces of the cathode 100 and the electrically charged substrate disposed on top of the electrostatic chuck 104 during processing. The baffle disk 244, made from electrically non-conductive material such as a ceramic material, prevents electrical discharge (e.g., arcing) within the cathode 100. In one embodiment, the baffle disk 244 is made of alumina (Al₂O₃).

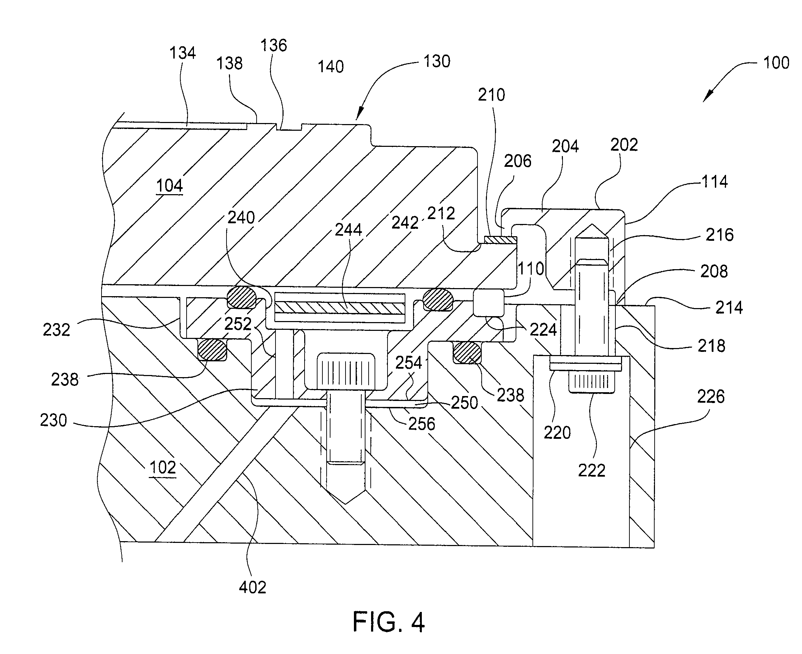

In the embodiment depicted in Figure 3A, the baffle disk 244 and gas distribution ring 230 are shown with the electrostatic chuck 104 removed. The location of the outer gas feed 140 is shown in phantom. Figure 3B depicts the gas distribution ring 230 with the baffle disk 244 removed such that the head of the fastener 234 disposed in the lower region of the stepped bore 240 is shown. With the baffle disk 244 removed in Figure 3B, the gas feed hole 252 formed through the gas distribution ring 230 is visible. The gas feed hole 252 couples the stepped counter bore 240 with a gas source (not shown) with a passage 402 formed through the cooling base 102, as shown in Figure 4.

As also illustrated in Figures 2 and 4, the support ring 110 may be retained on a ledge 224 formed on the periphery of the gas distribution ring 230. Alternatively, the support ring 110 may be located in a groove formed in at least one of the electrostatic chuck 104 or cooling base 102.

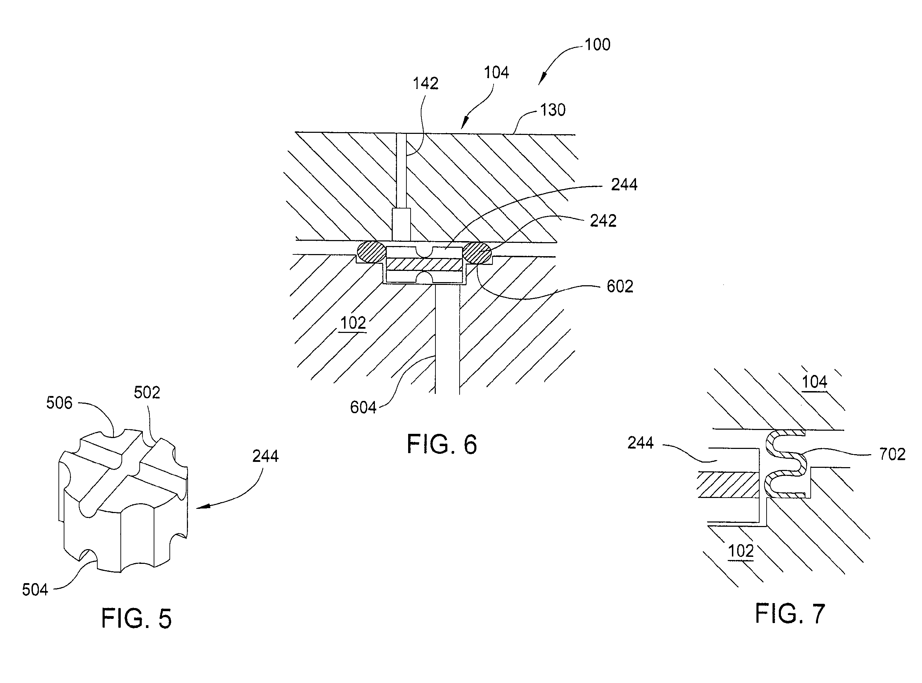

Figure 5 depicts one embodiment of the baffle disk 244. In the embodiment depicted in Figure 5, the upper and lower surfaces of the baffle disk 244 respectively include cross channels 502, 504, formed therein to enhance gas flow around the baffle disk 244. The baffle disk 244 may also include notches 506 formed in the perimeter of the plate 244 to further enhance flow from the lower surface to the upper surface of the baffle disk 244.

Figure 6 is another partial cross-sectional view of the cathode 100 illustrating a baffle disk 244 utilized below the inner gas feed 142. The baffle disk 244 is retained in a stepped bore 602, which is also utilized to retain a baffle seal 242. The baffle seal 242 provide a seal around the inner gas feed 142. Optionally, one or more of the seals described herein may be replace by an E-seal 702, such as shown in Figure 7. The E-seal 702 may be fabricated from a flexible metal and configured to provide a high temperature seal when compressed between the cooling base 102 and electrostatic chuck 104. In one embodiment, the E-seal 702 is fabricated from Ni-plated INCONEL^{®} 718 material. The E-seals 702 allow relative movement of the parts due to thermal expansion or contraction during heating and cooling while providing vacuum sealing of the area.

Returning to Figure 6, a lower region of the stepped bore 602 is coupled to a gas passage 604 utilized to couple the groove network 134 to a gas source (not shown) through the inner gas feed 142. As illustrated in Figure 6, the gas passage 604 and the inner gas feed 142 are offset to prevent line of sight alignment as discussed above. Additionally, the baffle disk 244 further obstructs the alignment between the feed 142 and passage 604 to provide an extra measure of protection without adversely affecting the flow of gas through the feed 142 from the passage 604.

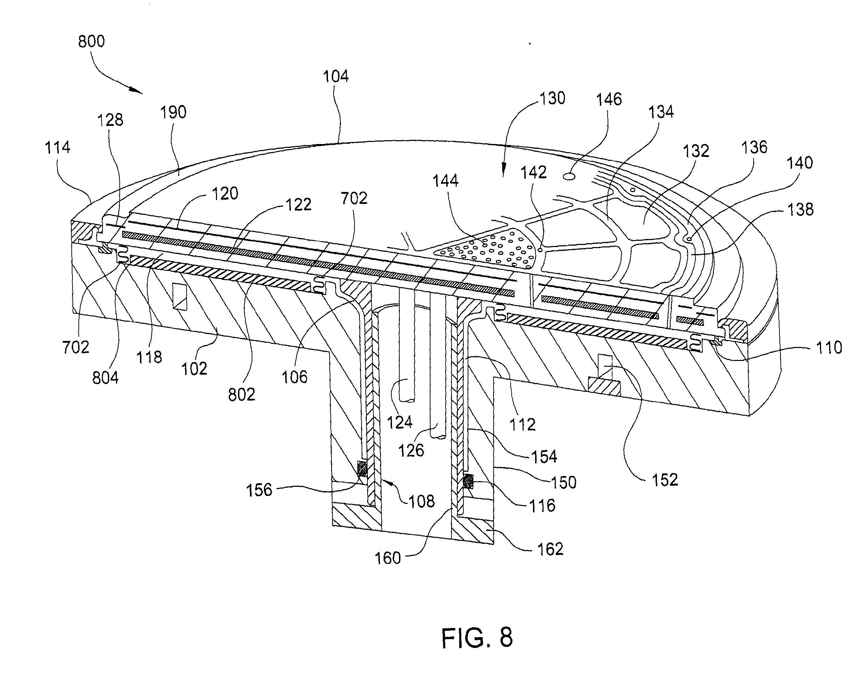

Figure 8 depicts another embodiment of a cathode 800. The cathode 800 is substantially similar to the cathode 100 and includes a spreader plate 802 disposed in a recess 804 of a cooling base 102. Annular seals, shown as E-seals 702, may be provided on each side of the spreader plate 802 to isolate the spreader plate 802 from gas pressure changes due to inadvertent gas leakage within the cathode 800. Alternatively, the E-seals 702 may allow a portion of the gap 118, for example the region containing the spreader plate 802, to be selectively flooded with a heat transfer gas such as helium to assist in regulating the heat transfer between the cooling base 102 and electrostatic chuck 104.

In one embodiment, the gap 118 between the bottom of the electrostatic 104 and the top of the cooling base 102 is configured to can accommodate a thin (e.g., about 0.020 to 0.060 inches) spreader plate 802. The spreader plate 802 is made of sturdy material with high thermal conductivity and high electrical resistivity (e.g., aluminum nitride, aluminum oxide, and the like). The spreader plate 802 beneficially makes heat flow from the electrostatic chuck 104 to the cooling base 102 more uniform by "spreading" any thermal non-uniformities caused by local features in the electrostatic chuck 104 or the base 102, such as backside He holes, or lift-pin holes, as well as caused by the heater 122 disposed in the chuck, imperfections with regard to the coolant channel pattern, and coolant temperature changes in the channel. The spreader plate 802 also allows greater distance between the electrostatic chuck 104 and the cooling base 102 without danger of igniting secondary plasma in the gap between the chuck and the cooling base due to electrical discharge in the filling gas in the gap. One example of a spreader plate which may be adapted to benefit from the invention is described in United States Patent Application Serial No. 10/440,365, filed May 16, 2003. The interior surfaces of a plasma etch processing chamber, such as described in United States Patent Application Serial Nos. 10/440,365 and 10/960,874 may be fabricated from, and/or coated with, a yttria comprising material. Examples of such yttria comprising surfaces include shields, process kits, wall liners, chamber walls, showerheads and gas delivery nozzles, among others.

In operation within a plasma etch reactor, heat produced by the heater 122 embedded in the electrostatic chuck 104 and heat gained by the chuck 104 from plasma is rejected to the cooling base 102 through the gap 118 and gap 112. In at least one embodiment, the base 102 and chuck 104 do not touch, and that the stem 106 coupled to the chuck 104 only comes close to the base 102 proximate the seal 116, such that the chuck and stem assembly essentially does not contact the base. The gap 118, which in one embodiment, is filled with helium, reduces the heat flux to the cooling base 102 in order to keep the surface of the electrostatic chuck 104 at significantly higher temperature than the cooling base 102. In some embodiments, a spreader plate 802 is utilized to reduce temperature non-uniformity, created by heater 122 due to a non-optimized heater power distribution and/or uneven cooling by the cooling base 102. The stem 106 is used to keep terminals of the electrostatic chuck 104 under atmospheric pressure in order to prevent arcing between terminals as well as between terminal and other parts. The stem 106 is long enough to allow placement of the o-ring 116 at a distance sufficient to allow heat removal from the stem 106 to occur at a rate suitable to prevent damage to the stem 106 or chuck 104, while reducing the temperature at the bottom of the stem 106 to a temperature below the melting point of the material of the o-ring 116.

Thus, embodiments of a cathode suitable for high temperature plasma etching have been provided. The cathode allows ceramic electrostatic chucks to operate at temperatures up to 450 degree Celsius in conjunction with cooling bases maintained in the range of about 20 to about 80 degree Celsius while preventing damage to cathode components due to thermal stress or exposure to high temperatures.

While the foregoing is directed to embodiments of the present invention, other and further embodiments of the invention may be devised without departing from the basic scope thereof, and the scope thereof is determined by the claims that follow.

## Claims

1. A plasma processing cathode (100) comprising:
a base (102) having cooling conduits formed therein;
a ceramic electrostatic chuck (104) secured to the base (102); and
a rigid support ring (110) disposed between the electrostatic chuck (104) and the base (102), the support ring (110) maintaining the electrostatic chuck (104) to the base (102) in a spaced-apart relation.

2. The cathode of claim 1 further comprising a gas distribution ring (203) disposed between the base (102) and chuck (104).

3. The cathode of claim 2 further comprising:
a gas passage formed through the base (102); and
a gas feed (140) formed through the electrostatic chuck (104), wherein the passage and feed are not aligned but fluidly coupled through the gas distribution ring (203) to define a gas delivery path, wherein gas delivery path extends through the gas distribution ring.

4. The cathode of claim 3 further comprising:
a ceramic baffle disk (244) disposed in the gas delivery path.

5. The cathode of claim 4, wherein the gas distribution ring further comprises:
a bore (240) having the baffle disk (244) disposed therein.

6. The cathode of any one of the preceding claims further comprising:
a gas passage formed through the base;
a gas feed (140) formed through the electrostatic chuck, wherein the passage and feed are not aligned but fluidly coupled through the gas distribution ring to define a gas delivery path; and
a ceramic baffle disk (244) disposed in the gas delivery path.

7. The cathode of any one of the preceding claims further comprising:
a flat annular spreader plate (802) disposed in a gap defined between the electrostatic chuck and the base, wherein the annular spreader plate is in contact with the base and spaced-apart from the electrostatic chuck.

8. The cathode of any one of the preceding claims further comprising:
a clamp ring (114) securing the electrostatic chuck and the base, wherein the clamp ring comprises at least two thermal chokes disposed in series between portions of the clamp ring touching the electrostatic chuck and the base.

9. The cathode of any one of the preceding claims further comprising:
a stem (106) coupled to the electrostatic chuck (104) and extending through the base (102);
a sleeve (160) disposed through the stem, wherein a first gap defined between the stem and base is greater than a second gap defined between the stem and sleeve; and
a seal disposed between a lower end of the stem and the base, the seal sealing the first gap.

10. A plasma processing cathode (100), in particular according to any one of the preceding claims, comprising:
a base (102) having cooling conduits formed therein;
a ceramic electrostatic chuck (104) disposed on the base, the electrostatic chuck having a plurality of gas feeds (140) extending from a bottom surface of the electrostatic chuck facing the base to a top surface the electrostatic chuck;
a rigid support ring (110) disposed between the electrostatic chuck and the base, the support ring maintaining the bottom of the electrostatic chuck and the base in a spaced-apart relation;
a fluid distribution ring disposed between the base and the electrostatic chuck, a bottom of the fluid distribution ring spaced from the base to define an annular channel, the fluid distribution ring having a plurality of gas passages configured to direct gas through the fluid distribution ring from the channel to the electrostatic chuck; and
ceramic baffles disposed in the gas passages.

11. The cathode of claim 10, wherein at least one of the ceramic baffles further comprises:
a disk-like body (244) having an upper surface, a lower surface and a perimeter; and
at least one of cross channels (502, 504) formed in the upper and lower surfaces and notches (506) formed in the perimeter of the body (244).

12. The cathode of any one of the preceding claims, further comprising:
an annular spreader plate disposed in a gap defined between the electrostatic chuck and the base, wherein the annular spreader plate is in contact with the base and spaced-apart from the electrostatic chuck.

13. A plasma processing cathode (100), in particular according to any one of the preceding claims, comprising:
a base (102) having cooling conduits formed therein;
a ceramic electrostatic chuck (104) secured to a top surface of the base;
a rigid support ring (110) disposed between the electrostatic chuck and the base, the support ring maintaining a lower surface of the electrostatic chuck spaced-apart from the top surface of the base;
a flat annular spreader plate disposed radially inward of the support ring in a gap defined between the lower surface of the electrostatic chuck (104) and the upper surface of the base (102); and
a seal providing seal between the electrostatic chuck and the base outward of the spreader plate, the seal sealingly permitting radial movement of the electrostatic chuck relative to the plate.

14. The cathode of any one of claims 2 to 13, further comprising:
a gas passage formed through the base;
a gas feed formed through the electrostatic chuck, wherein the passage and feed are not aligned but fluidly coupled through the gas distribution ring to define a gas delivery path, and
a ceramic baffle disk disposed in the gas delivery path.

15. The cathode of any one of the preceding claims, further comprising:
a fluid distribution ring disposed between the base and the electrostatic chuck, a bottom of the fluid distribution ring spaced from the base to define an annular channel, the fluid distribution ring comprising:
a stepped bore formed on a top surface facing the electrostatic chuck, the bore receiving the baffle therein;
a gas passage having a first end breaking into the stepped bore and a second end breaking through the bottom of the fluid distribution ring and exposed to the annular channel.
